# EUROPÄISCHE PATENTSCHRIFT

(11) **EP 0 599 122 B1**
(45) Veröffentlichungstag und Bekanntmachung des Hinweises auf die Patenterteilung: **16.08.1995**
(21) Anmeldenummer: 93118077.2
(22) Anmeldetag: 08.11.1993
(51) Int. Cl.: H05K 3/42

(54) **Verfahren zum Herstellen von durchkontaktierten Leiterplatten mit sehr kleinen oder keinen Lötaugen**
Process for producing plated through-hole printed circuit boards having very small solder lands or no solder lands
Procédé de fabrication de plaques de circuit imprimé à trous traversants comportant de très petits oeillets de soudage ou n'en comportant pas

(30) Priorität: 23.11.1992 DE 4239328
(43) Veröffentlichungstag der Anmeldung: 01.06.1994
(73) Patentinhaber: Siemens Nixdorf Informationssysteme Aktiengesellschaft, 33102 Paderborn (DE)
(72) Erfinder: Merkenschlager, Hans-Hermann, Dipl.-Ing., D-86179 Augsburg (DE); Zeidler, Wolfgang, D-86179 Augsburg (DE)
(74) Vertreter: Fuchs, Franz-Josef, Dr.-Ing.

(56) Entgegenhaltungen:
- EP-A- 0 178 864
- DE-A- 3 917 923
- PATENT ABSTRACTS OF JAPAN vol. 013, no. 558 (E-858)12. Dezember 1989 & JP-A-01 231 397 (NEC CORP) 14. September 1989

## Beschreibung

### Verfahren zum Herstellen von durchkontaktierten Leiterplatten mit sehr kleinen oder keinen Lötaugen

Die Erfindung betrifft ein Verfahren zum Herstellen von durchkontaktierten Leiterplatten mit sehr kleinen oder keinen Lötaugen um die Durchkontaktierungslöcher nach dem Tenting-Verfahren, bei dem vor dem Aufbringen der Fotofolie ein dünner ätzfester Schutzfilm auf die Oberfläche und in den Durchkontaktierungen der Leiterplatte aufgebracht wird.

Durchkontaktierte Leiterplatten mit kleinen Lötaugen werden bisher überwiegend in sogenannter Metallresist-Technik, nicht aber im Tenting-Verfahren hergestellt. Gegenüber dem Tenting-Verfahren, bei dem wie aus DE-A-31 08 080 bekannt, vor dem Ätzschritt das Leiterbild, die Lötaugen und die Durchkontaktierungslöcher der Leiterplatte mit Fotofolie abgedeckt werden, sind bei Anwendung der Metallresist-Technik mehr Galvanikschritte erforderlich und das Verfahren ist im ganzen nicht so automatisierungsfreudig wie das Tenting-Verfahren. Beim Tenting-Verfahren schützt die Maske aus Fotofolie während des Ätzvorganges die abgedeckten Bereiche vor dem Angriff der Ätze, während an den übrigen Stellen das Kupfer abgetragen und so die Leiterbahnstruktur erzeugt wird. Bei Anwendung des Tenting-Verfahrens ist aber ein Problem der Schutz von metallisierten Durchkontaktierungslöchern. Falls die Lötaugen um die Durchkontaktierungslöcher herum zu klein sind oder sogar wegfallen können, besteht die Gefahr, daß die das Loch abdeckende Fotofolie aufreißt, dadurch Ätze in das Durchkontaktierungsloch eindringt, die Kupfermetallisierung in dem Durchkontaktierungsloch abträgt und damit die Durchkontaktierung selbst zerstört.

Um das Abtragen der Kupfermetallisierung in dem Durchkontaktierungsloch zu vermeiden, ist ebenfalls aus der DE-A-31 08 080 bekannt, vor dem Aufbringen der Fotofolie und vor dem Ätzprozeß die Durchkontaktierungslöcher mit Siebdruckpaste zu füllen und damit gegen das Eindringen von Ätze zu schützen. Diese Methode ist aber relativ umständlich und aufwendig.

In der DE-B-11 42 926 wird vorgeschlagen, daß entweder die Bohrungen, wie bereits berücksichtigt, mit Ätzpaste ausgefüllt werden, oder daß eine Folie vor dem Ätzen aufgebracht wird, wobei jedoch auf die Gefahr des Verletzens dieser Folie über den Löchern und deren Abwendung nicht eingegangen wird.Anschließend werden die metallisierten Lochwandungen mit einem Metallresist, wie z.B. Gold oder Zinn benetzt, also einem üblichen Verfahren.

Aus der DE-A-18 11 377 ist zu entnehmen, daß unmittelbar nach dem Abscheiden des Metallbelags in den Bohrungen lediglich die Wandungen der Bohrungen verzinnt werden sollen, bzw. daß zur Erzielung einer Verzinnung lediglich auf den Wandungen der Bohrungen die beiden Oberflächen der Leiterplatten nach dem Abscheiden des Metallbelags und vor dem Verzinnen, vorzugsweise mit einem Lack abgedeckt werden, der später wieder entfernt wird, wobei jedoch die Bohrungen selbst offensichtlich von diesem Lack freibleiben sollen.

Aus der DE-A-39 17 923 A1 ist es außerdem beim Tenting-Verfahren bereits bekannt, die Leiterplatte vor dem Beschichten mit Fotofolie in eine Lösung zu tauchen, die auf allen Kupferflächen eine ätzfeste Schutzschicht erzeugt. Diese Schutzschicht wird anschließend von der Oberfläche der Leiterplatte mit Ausnahme der Durchkontaktierungslöcher wieder entfernt. Danach werden die Leiterbahnen und die Durchkontaktierungslöcher der Leiterplatte mit einer Fotofolie abdeckt. Die Leiterplatte wird dann geätzt und nach dem Ätzen und dem Entschichten der Fotofolie wird die ätzfeste Schutzschicht in den Durchkontaktierungslöchern wieder entfernt. Bei diesem Verfahren wird die ätzfeste Schutzschicht auf der Oberfläche der Leiterplatte mechanisch entfernt.

Aufgabe der vorliegenden Erfindung ist es, ein Verfahren zum Herstellen von durchkontaktierten Leiterplatten mit sehr kleinen oder keinen Lötaugen um die Durchkontaktierungslöcher nach dem Tenting-Verfahren anzugeben, bei dem keine mechanischen Verfahrensschritte zur Entfernung der Schutzschicht notwendig sind.

Zur Lösung dieser Aufgabe wird gemäß der Erfindung derart verfahren, daß nach dem Freientwickeln des Leiterbildes der ätzfeste Schutzfilm von der freien Kupferoberfläche, jedoch nicht in den Durchkontaktierungslöchern durch kurzzeitiges Behandeln in Säure entfernt wird, daß dann die Leiterbildstruktur mittels alkalischer Ätze erzeugt und nach dem Entschichten der restlichen Fotofolie der Schutzfilm von den Wänden der Durchkontaktierungslöcher durch eine weitere Säurebehandlung entfernt wird.

Anstelle der Säure zur Entfernung der Schutzschicht, sind auch andere Lösungsmittel denkbar, die weder die Fotofolie, noch die Metallschicht angreifen.

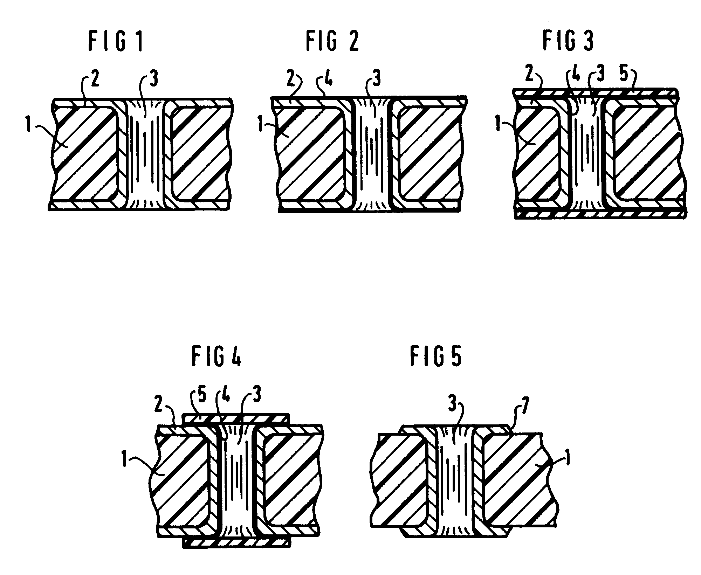

Anhand der Ausführungsbeispiele nach den Figuren 1 bis 5, wird die Erfindung näher erläutert.

Dadurch wird ein aufwendiges mechanisches Verfahren zur Entfernung der Schutzschicht durch ein chemisches ersetzt, wodurch eine erhebliche Vereinfachung des Herstellungsverfahrens von Leiterplatten nach dem Tenting-Verfahren erzielt wird.

Figur 1 zeigt als Schnittdarstellung einen Teil einer Leiterplatte 1 mit einer Kupferbeschichtung 2, die sich auch im Innern des Durchkontaktierungsloches 3 fortsetzt. Durch Eintauchen einer solchen Leiterplatte, z.B. in eine Imidazollösung bildet sich auf allen Kupferflächen 2 der Leiterplatte eine ätzfeste Schutzschicht 4, wie in Figur 2 angedeutet ist. Danach wird entsprechend dem Tenting-Verfahren eine Fotofolie 5 aufgebracht, wie in Figur 3 gezeigt. Nach dem Freientwickeln des Leiterbildes wird der ätzfeste Schutzfilm 4, wie in Figur 4 dargestellt, von der freien Kupferoberfläche jedoch nicht in den Durchkontaktierungslöchern 3 durch kurzzeitiges Behandeln in Säure entfernt. Danach wird die Leiterbildstruktur mittels alkalischer Ätze erzeugt und nach dem Entschichten der restlichen Fotofolie 5 der Schutzfilm 4 von den Wänden der Durchkontaktierungslöcher 3 durch eine weitere Säurebehandlung entfernt. Figur 5 zeigt schließlich das Ergebnis des Verfahrens nach der Erfindung, d.h. die außerhalb des Kontaktierungsloches und seiner Lötränder weggeätzte Kupferschicht 7 und das unversehrte Durchkontaktierungsloch 3.

## Patentansprüche

1. Verfahren zum Herstellen von durchkontaktierten Leiterplatten nach dem Tenting-Verfahren, bei dem vor dem Aufbringen der Fotofolie ein dünner ätzfester Schutzfilm auf die Oberfläche und in den Durchkontaktierungen der Leiterplatte aufgebracht wird,
**dadurch gekennzeichnet,**
daß nach dem Freientwickeln des Leiterbildes in die Fotofolie (5) der ätzfeste Schutzfilm (4) von der Kupferoberfläche (2), jedoch nicht in den Durchkontaktierungslöchern (3) durch kurzzeitiges Behandeln in Säure entfernt wird, daß dann die Leiterbildstruktur mittels alkalischer Ätze in die Kupferschicht erzeugt und nach dem Entschichten der restlichen Fotofolie (5) der Schutzfilm (4) von den Wänden der Durchkontaktierungslöcher (3) durch eine weitere Säurebehandlung entfernt wird.

## Claims

1. Process for producing plated-through printed circuit boards according to the tenting process, in which, prior to the application of the photographic film, a thin etchresistant protective film is applied to the surface and the plated-through holes of the printed circuit board, characterized in that, after the conductor pattern has been developed in the photographic film (5), the etch-resistant protective film (4) is removed from the copper surface (2), but not from the plated-through holes (3), by brief treatment in acid, in that the conductor pattern structure is then produced in the copper layer by means of alkaline etchant and, after the rest of the photographic film (5) has been stripped, the protective film (4) is removed from the walls of the plated-through holes (3) by a further acid treatment.

## Revendications

1. Procédé de fabrication de plaquettes à circuits imprimés interconnectés selon le procédé Tenting, selon lequel avant le dépôt de la feuille photosensible, on dépose une mince pellicule de protection, résistante à l'attaque chimique, sur la surface et dans les interconnexions de la plaquette à circuits imprimés,
caractérisé par le fait qu'après le développement de l'impression conductrice dans la feuille photosensible (5), on élimine la pellicule de protection (4) résistante à l'attaque chimique, de la surface de cuivre (2), mais pas dans les interconnexions (3), par un traitement de brève durée dans de l'acide, puis on forme la structure d'impression des conducteurs dans la couche de cuivre au moyen d'une attaque chimique alcaline et après enlèvement de la feuille photosensible restante (5), on élimine la pellicule de protection (4), des parois des trous (3) d'interconnexions par un traitement supplémentaire à l'acide.
